(19) Europäisches Patentamt
European Patent Office
Office européen des brevets

(11) Veröffentlichungsnummer: **0 619 646 A2**

# (12) EUROPÄISCHE PATENTANMELDUNG

(21) Anmeldenummer: **94200876.4**

(51) Int. Cl.$^{5}$: **H03F 3/45**

(22) Anmeldetag: **30.03.94**

(30) Priorität: **07.04.93 DE 4311411**

(43) Veröffentlichungstag der Anmeldung:
**12.10.94 Patentblatt 94/41**

(84) Benannte Vertragsstaaten:
**DE FR GB**

(71) Anmelder: **Philips Patentverwaltung GmbH**
**Wendenstrasse 35c**
**D-20097 Hamburg (DE)**
(84) **DE**

(71) Anmelder: **N.V. Philips' Gloeilampenfabrieken**
**Groenewoudseweg 1**
**NL-5621 BA Eindhoven (NL)**
(84) **FR GB**

(72) Erfinder: **Brilka, Joachim, c/o Philips Patentverwaltung GmbH**
**Wendenstrasse 35**
**D-20097 Hamburg (DE)**

(74) Vertreter: **von Laue, Hanns-Ulrich, Dipl.-Ing. et al**
**Philips Patentverwaltung GmbH**
**Wendenstrasse 35c**
**D-20097 Hamburg (DE)**

## (54) Verstärkeranordnung.

(57) Bei einer "Rail to Rail"-Verstärkeranordnung ist für möglichst geringe Signaleinflüsse auf das Bezugspotential vorgesehen, daß diese einen ersten Differenzverstärker, der einen ersten und einen zweiten Transistor aufweist, deren Emitter über einen gemeinsamen ersten Widerstand mit einem Bezugspotential gekoppelt sind, wobei der Kollektor des ersten Transistors den Ausgangsknoten der Verstärkeranordnung bildet, einen zweiten Differenzverstärker, dem eingangsseitig das Eingangssignal der Verstärkeranordnung zugeführt wird, der ausgangsseitig mit der Basis des ersten Transistors des ersten Differenzverstärkers gekoppelt ist und der einen invertierenden Eingang aufweist, der mit dem Ausgangsknoten der Verstärkeranordnung gekoppelt ist, eine erste Stromspiegelanordnung, deren Eingangstransistor ein Referenzstrom zugeführt wird, deren Ausgangstransistor mit dem zweiten Transistor des ersten Differenzverstärkers identisch ist und deren beide Transistoren emitterseitig mit einem Bezugspotential gekoppelt sind, und eine zweite Stromspiegelanordnung aufweist, der eingangsseitig das Ausgangssignal der ersten Stromspiegelanordnung zugeführt wird, welche ausgangsseitig mit dem Ausgangsknoten der Verstärkeranordnung gekoppelt ist, deren beide Transistoren emitterseitig mit einem Versorgungspotential gekoppelt sind und deren Transistoren bezüglich ihres Flächenverhältnisses so ausgelegt sind, daß die Stromspiegelanordnung ausgangsseitig einen gegenüber dem ihr zugeführten Eingangsstrom einen doppelt so großen Strom liefert.

EP 0 619 646 A2

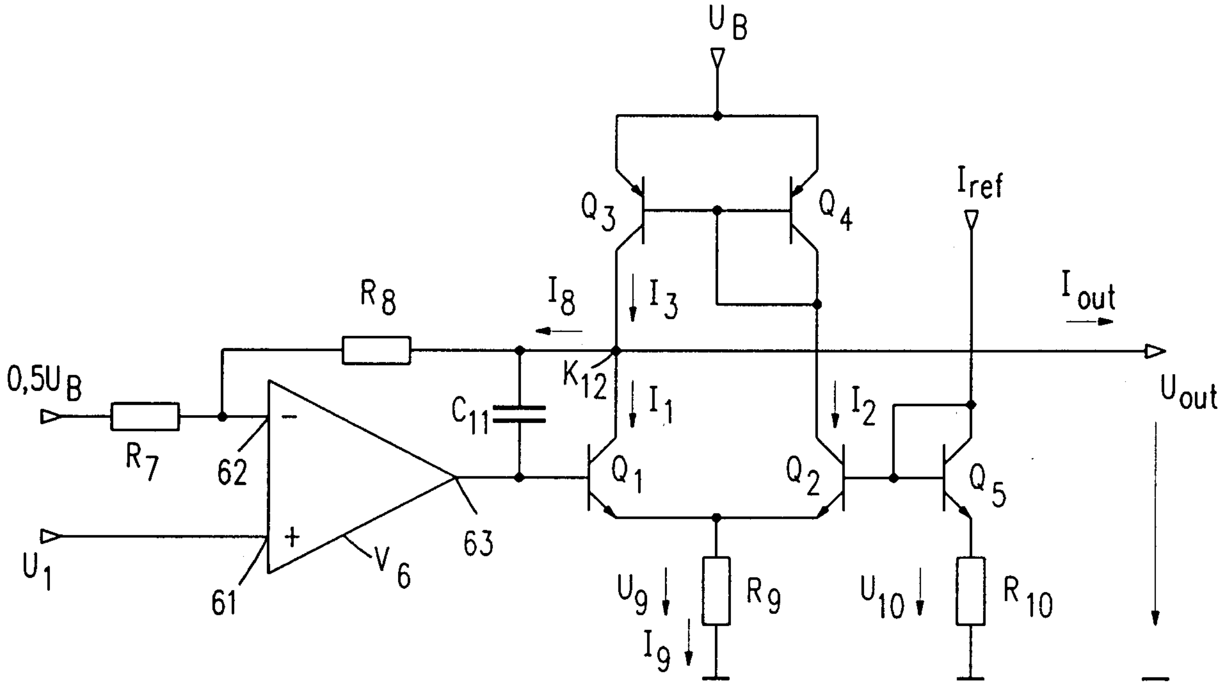
U_B
Q_3
Q_4
I_ref
R_8
I_8
I_3
I_out
0,5U_B
K_12
C_11
I_1
I_2
U_out
R_7
62
Q_1
Q_2
Q_5
63
U_1
V_6
61
U_9
R_9
U_10
R_10
I_9

Die Erfindung betrifft eine "Rail to Rail"-Verstärkeranordnung, die einen großen Aussteuerungsbereich aufweist, der von nahezu dem Bezugspotential bis nahezu der Versorgungsspannung erreicht.

Insbesondere bei derartigen Verstärkeranordnungen mit großem Aussteuerbereich existiert das Problem, daß ein Teil des Ausgangsstroms zum Bezugspotential abfließt, daß also auf der Masseleitung ein nicht unbeträchtlicher Teil des Signalstroms vorhanden ist. Dies ist insbesondere für integrierte Schaltkreise nicht erwünscht, da die Masseverbindungen der IC's solche Widerstände aufweisen, daß bei einem Stromfluß auf den Masseleitungen das Bezugspotential nicht mehr konstant bleibt. Dadurch werden andere Schaltungen auf dem IC gestört, d.h. es findet über das Bezugspotential ein Übersprechen der Ausgangssignale der Verstärkeranordnung auf andere auf dem gleichen IC vorgesehene Schaltungselemente statt.

Es ist Aufgabe der Erfindung, den Einfluß des Ausgangs-Signalstroms der Verstärkeranordnung auf der Masseleitung zu verringern.

Die Lösung dieser Aufgabe gelingt durch eine Verstärkeranordnung

- mit einem ersten Differenzverstärker, der einen ersten und einen zweiten Transistor aufweist, deren Emitter über einen gemeinsamen ersten Widerstand mit einem Bezugspotential gekoppelt sind, wobei der Kollektor des ersten Transistors einen Ausgangsknoten der Verstärkeranordnung bildet,
- mit einem zweiten Differenzverstärker, dem eingangsseitig das Eingangssignal der Verstärkeranordnung zugeführt wird, der ausgangsseitig mit der Basis des ersten Transistors des ersten Differenzverstärkers gekoppelt ist und der einen invertierenden Eingang aufweist, der mit dem Ausgangsknoten der Verstärkeranordnung gekoppelt ist,
- mit einer ersten Stromspiegelanordnung, deren Eingangstransistor ein Referenzstrom zugeführt wird, deren Ausgangstransistor mit dem zweiten Transistor des ersten Differenzverstärkers identisch ist und deren beide Transistoren emitterseitig mit einem Bezugspotential gekoppelt sind,
- und mit einer zweiten Stromspiegelanordnung, der eingangsseitig das Ausgangssignal der ersten Stromspiegelanordnung zugeführt wird, die ausgangsseitig mit dem Ausgangsknoten der Verstärkeranordnung gekoppelt ist, deren beide Transistoren emitterseitig mit einem Versorgungspotential gekoppelt sind und deren Transistoren bezüglich ihres Flächenverhältnisses so ausgelegt sind, daß die Stromspiegelanordnung ausgangsseitig einen gegenüber dem ihr zugeführten Eingangsstrom doppelt so großen Strom liefert.

In dieser Anordnung können grundsätzlich Einflüsse des Ausgangssignals der Verstärkeranordnung, das an dem Ausgangsknoten abnehmbar ist, über den ersten Widerstand auf Massepotential stattfinden. Diese Einflüsse sind jedoch sehr gering. Dies liegt daran, daß eine Art Stromgegenkopplung des ersten Differenzverstärkers und der ersten Stromspiegelanordnung stattfindet. Dies gelingt dadurch, daß der zweite Transistor des ersten Differenzverstärkers und der Ausgangstransistor der ersten Stromspiegelanordnung identisch sind. Auch der erste Widerstand ist somit sowohl für den ersten Differenzverstärker wie auch für die erste Stromspiegelanordnung als Verbindung zum Massepotential wirksam.

Die Verringerung des Einflusses des Ausgangs-Signalsstroms der Verstärkeranordnung auf das Bezugspotential entsteht dadurch, daß der zweite Transistor des ersten Differenzverstärkers einer Stromänderung, die durch den ersten Transistor des Differenzverstärkers bzw. den ihn ansteuernden zweiten Differenzverstärker ausgelöst wird, entgegensteuert. Wird nämlich der Strom durch den ersten Transistor des ersten Differenzverstärkers größer, so wird durch die Gegenkopplung mit dem ersten Widerstand der Strom des zweiten Transistors des ersten Differenzverstärkers geringer. Damit wird auch der Strom der ersten Stromspiegelanordnung, deren Ausgangstransistor mit dem zweiten Transistor des ersten Differenzverstärkers identisch ist, geringer. Dieser entsprechend geringere Strom wird auch durch die zweite Stromspiegelanordnung, die den Strom mit einem Faktor 2 multipliziert, entsprechend geringer. Damit bleibt der Strom durch den Widerstand $R_9$ näherungsweise konstant und es findet ein nur sehr geringer Einfluß des Ausgangssignalstroms der Verstärkeranordnung auf das Bezugspotential statt.

Diese Eigenschaft der Verstärkeranordnung kann, wie nach einer weiteren Ausgestaltung der Erfindung vorgesehen ist, vorteilhaft dadurch unterstützt werden, daß der Emitter des Eingangstransistors der ersten Stromspiegelanordnung über einen zweiten Widerstand mit Bezugspotential gekoppelt ist, an dem etwa eine Spannung des gleichen Spannungswertes abfällt wie an dem ersten Widerstand.

Auf einen invertierenden Eingang des zweiten Differenzverstärkers wird das Signal des Ausgangsknotens der Verstärkeranordnung rückgekoppelt. Je nach gewünschtem Maß der Verstärkung des Eingangssignals der Verstärkeranordnung und in Abhängigkeit davon, ob das Eingangssignal invertiert oder nicht invertiert werden soll, sind verschiedene Belegungen der Eingänge des zweiten Differenzverstärkers möglich. Soll das Eingangssignal nicht invertiert werden, so besteht, wie nach einer weiteren Ausgestaltung der Erfindung vorgesehen ist, die vorteilhafte Möglichkeit, daß das Eingangssignal der Verstärkeranordnung einem invertierenden Eingang des zweiten Differenzverstärkers zugeführt wird und daß der invertierende Eingang mit dem Ausgangsknoten der Verstärkeranordnung und dem halben Wert des Versorgungspotentials gekoppelt ist.

Im allgemeinen wird das Versorgungspotential gegenüber dem Bezugspotential positive Spannungswerte aufweisen. In diesem Falle sind in einer weiteren Ausgestaltung der Erfindung die beiden Transistoren des ersten Differenzverstärkers sowie der Eingangstransistor der ersten Stromspiegelanordnung vom Leitfähigkeitstyp NPN und die beiden Transistoren der zweiten Stromspiegelanordnung vom Leitfähigkeitstyp PNP zu wählen.

Nachfolgend wird anhand der einzigen Figur der Zeichnung ein Ausführungsbeispiel der Erfindung näher erläutert.

Bei diesem Ausführungsbeispiel für die erfindungsgemäße Verstärkeranordnung ist ein Versorgungspotential vorgesehen, das gegenüber Bezugspotential positive Spannungswerte aufweist.

Die Figur zeigt eine Verstärkeranordnung mit einem ersten Differenzverstärker, der Transistoren $Q_1$ und $Q_2$ aufweist, mit einem zweiten Differenzverstärker, der als Operationsverstärker $V_6$ ausgeführt ist, mit einer ersten Stromspiegelanordnung, die Transistoren $Q_5$ und $Q_2$ aufweist,und mit einer zweiten Stromspiegelanordnung, welche Transistoren $Q_4$ und $Q_3$ aufweist.

Ein der Verstärkeranordnung eingangsseitig zugeführtes Eingangssignal $U_1$ wird einem nicht invertierenden Eingang 61 des Operationsverstärkers $V_6$ zugeführt. Über einen Widerstand $R_7$ gelangt ferner ein in der Figur mit 0,5 $U_B$ bezeichnetes Versorgungspotential, das den halben Wert eines Versorgungspotentials $U_B$ aufweist, auf einen invertierenden Eingang 62 des Operationsverstärkers $V_6$.

Ein Ausgang 63 des Operationsverstärkers $V_6$ ist gekoppelt mit der Basis des ersten Transistors $Q_1$ des ersten Differenzverstärkers. Ferner ist das am Ausgang 63 anliegende Signal über einen Kondensator $C_{11}$ mit dem Ausgangsknoten $K_{12}$ der Verstärkeranordnung einerseits sowie über einen Widerstand $R_8$ mit dem invertierenden Eingang 62 des Operationsverstärkers $V_6$ gekoppelt.

An dem Ausgangsknoten $K_{12}$ der Verstärkeranordnung steht deren Ausgangssignal zur Verfügung.

Der erste Differenzverstärker weist ferner einen zweiten Transistor $Q_2$ auf, der emitterseitig mit dem Emitter des Transistors $Q_1$ verbunden ist. Beide sind über einen Widerstand $R_9$ mit dem Bezugspotential gekoppelt.

Der ersten Stromspiegelanordnung, die die Transistoren $Q_5$ und $Q_2$ aufweist, wird eingangsseitig ein Referenzstrom zugeführt, der in der Figur mit $I_{ref}$ bezeichnet ist.

Dem Kollektor und der Basis des Eingangstransistors $Q_5$ der ersten Stromspiegelanordnung wird dieser Referenzstrom $I_{ref}$ zugeführt. Der Emitter ist über einen Widerstand $R_{10}$ mit Bezugspotential gekoppelt. Die Basis des Eingangstransistors $Q_5$ der ersten Stromspiegelanordnung ist mit der Basis des zweiten Transistors $Q_2$ der Stromspiegelanordnung verbunden. Dieser zweite Transistor $Q_2$ der ersten Stromspiegelanordnung ist identisch mit dem zweiten Transistor $Q_2$ des ersten Differenzverstärkers, dessen Emitter über den Widerstand $A_9$ auf Bezugspotential geführt ist.

Der Kollektor des Transistors $Q_2$ ist mit dem Kollektor und der Basis eines Eingangstransistors $Q_4$ der zweiten Stromspiegelanordnung verbunden. Dieser Eingangstransistor ist mit seinem Emitter auf Versorgungspotential $U_B$ geführt,ebenso wie ein Ausgangstransistor $Q_3$ dieser zweiten Stromspiegelanordnung. Die Basen der beiden Transistoren der Stromspiegelanordnung sind miteinander verbunden. Der Kollektor des Ausgangstransistors der Stromspiegelanordnung ist an den Ausgangsknoten $Q_{12}$ geführt.

Dabei sind die Flächenverhältnisse der Transistoren $Q_2$ und $Q_5$ etwa gleich, während die Flächenverhältnisse der Transistoren $Q_4$ und $Q_3$ der zweiten Stromspiegelanordnung so ausgelegt sind, daß diese ausgangsseitig einen doppelt so großen Strom liefert, wie er eingangsseitig zugeführt wird.

In der Zeichnung ist das Ausgangssignal, das der Knoten $K_{12}$ der Verstärkeranordnung liefert, herausgeführt, und dessen Spannungswert gegenüber Bezugspotential mit $U_{out}$ bezeichnet. Der aus dem Knoten herausfließende Strom ist mit $I_{out}$ gekennzeichnet.

Im folgenden wird die Funktionsweise der Verstärkeranordnung näher erläutert, wobei davon ausgegangen wird, daß entsprechend der Darstellung der Figur der aus dem Ausgangsknoten in den Kollektor des Transistors $Q_1$ fließende Strom mit $I_1$ bezeichnet wird, daß der aus dem Kollektor des Transistors $Q_3$ zum Ausgangsknoten fließende Strom mit $I_3$ bezeichnet wird, daß der vom Ausgangsknoten zum Kondensator $C_{11}$ bzw. dem Widerstand $R_8$ fließende Strom mit $I_8$ bezeichnet wird und daß der vom Kollektor des Transistors $Q_4$ zum Kollektor des Transistors $Q_2$ fließende Strom mit I2 bezeichnet wird.

Für die Betrachtung der Wirkungsweise der Schaltung soll zunächst davon ausgegangen werden, daß kein Ausgangstrom $I_{out}$ fließt.

In jedem Falle gilt, daß die Stromsumme am Ausgangsknoten $K_{12}$ = 0 sein muß. Es gilt also:

$$I_{out} + I_1 + I_8 - I_3 = 0 \qquad (1)$$

Das Flächenverhältnis der Transistoren $Q_3$ und $Q_4$ ist, wie oben ausgeführt, so ausgelegt, daß gilt:

$I_1 \approx I_3 = 2\ I_2$ (2)

Dabei wird vorausgesetzt, daß der Ausgangsstrom $I_{out} = 0$ ist und daß der Strom $I_8$ sehr viel kleiner ist als der Strom $I_3$.

Damit gilt auch

$I_9 = I_1 + I_2 = 3\ I_2$ (3)

Wenn ferner $R_{10} = 3\ R_9$ gewählt wird, so gilt wegen $I_9 = 3\ I_2$:

$I_2 = I_{ref}$ (4)

Der Aussteuerungsbereich der Verstärkeranordnung, also der Spannungsbereich des Ausgangssignals $U_{out}$ reicht nahezu vom Bezugspotential bis Versorgungspotential; es handelt sich also um einen sogenannten Rail to Rail-Verstärker.

Die Ausgangsspannung $U_{out}$ kann nämlich den gesamten Aussteuerungsbereich von $U_B$ - $U_{CESAT}$ ($Q_3$) bis $U_9$ + $U_{CESAT}$ ($Q_1$) annehmen.

Wenn die Widerstände $R_9$ und $R_{10}$ so gewählt werden, daß die Spannungen $U_{10}$ (an $R_{10}$) und $U_9$ (an $R_9$) ungefähr gleich 200 m sind, kann man dagegen unterschiedliche Basis-Emitter-Spannungen der Transistoren $Q_2$ und $Q_5$ in erster Näherung vernachlässigen. Diese unterschiedlichen Spannungen treten bei einem Ausgangsstrom $I_{OUT}$ ungleich Null auf, weil dann $I_2$ nicht mehr gleich $I_{ref}$ ist, wie später gezeigt wird.

Für diese Basis-Emitter-Spannung eines Transistors gilt für unterschiedliche Kollektorströme $I_{c1}$ und $I_{c2}$:

$$\Delta\ U_{BE} = U_T \cdot \ln\left(\frac{I_{c1}}{I_{c2}}\right) \qquad (5)$$

Für das Eingangssignal $U_1$ und das Ausgangssignal $U_8$ gilt folgende Beziehung:

$$U_{out} = \left(1+\frac{R_8}{R_7}\right) \cdot (U_1 - 0{,}5 U_B) \qquad (6)$$

Ist der Ausgangsstrom $I_{out}$ der Verstärkeranordnung nicht gleich Null, wird $Q_1$ durch den zweiten Differenzverstärker $V_6$ so gesteuert, daß der Ausgangsstrom durch den Transistor $Q_1$ zum Bezugspotential fließt, da die Stromsumme im Knoten K12 gleich Null sein muß (Gleichung (1)). Mit der Gleichung (3) gilt damit:

$I_9' = I_1' + I_2' + I_{out} = 3\ I_2' + I_{out}$ (7)

Soll jedoch $I_9$ näherungsweise konstant bleiben, d.h. also sich nicht mit $I_{out}$ ändern, muß gelten: $I_9' = I_9$. Damit gelten, in Verbindung mit den Gleichungen (3) und (7) folgende Beziehungen:

$3\ I_2' + I_{out} = 3\ I_2 = 3\ I_{ref}$. (8)

oder

$I_2' = I_{ref} - 0.33\ I_{out}$ (9)

In Verbindung mit der Gleichung (5) muß, wenn der Strom $I_2$ seinen Wert $I_2'$ erreichen soll, gelten:

$$\Delta U_{BE}(Q_2) = U_T \cdot \ln\left(1 - 0{,}33 \frac{I_{out}}{I_{ref}}\right) \qquad (10)$$

Diese Gleichung bedeutet mit

$\Delta U_9 = - \Delta U_{BE} (Q_2)$     (11)

daß, wenn z.B. ein Strom $I_{out}$ fließt, der kleiner 0 ist, dieser Strom in den Knoten $K_{12}$ und über $Q_1$ und $R_9$ auf Masse fließt. Dabei wird jedoch $Q_1$ durch den zweiten Differenzverstärker $V_6$ so gesteuert, daß weiterhin Gleichung (11) gilt, d.h., der Strom $I_2$ nimmt um das 0,33-fache des Stromes $I_{out}$ ab. Wegen der Beziehung gemäß Gleichung (2) nimmt dabei jedoch $I_3$ um den Faktor 0,66 • $I_{out}$ ab. Daraus folgt mit den Gleichungen (1) und (3), daß sich der Strom $I_9$ näherungsweise nicht ändert bzw. sich nur wenig ändert.

Es entsteht jedoch eine Regelabweichung an $R_9$, die an diesem eine Spannung $U_9$ erzeugt, die wegen der Gleichungen (10) und (11) von $I_{out}$ logarithmisch abhängt. Wenn z.B. die Ströme $I_{out}$ und $I_{ref}$ den gleichen Wert aufweisen und an dem Widerstand $R_9$ eine Spannung $U_9$ = 200 mV abfällt, so gilt in Verbindung mit den Gleichungen (7), (10) und (11):

$\Delta I_9 \approx 0{,}15 \cdot I_{out}$.

Dies bedeutet, daß bei dem Widerstand $R_9$ nur etwa 15 % des Ausgangsstromes fließen. Damit wird auf das Bezugspotential auch nur ein geringer Strom geführt. Dies gilt sowohl für Ausgangs-Gleichströme wie auch für Signalströme.

Dieser geringe Einfluß des Ausgangsstroms $I_{out}$ auf den auf Bezugspotential fließenden Strom $I_9$ hat den Vorteil, daß beispielsweise dann, wenn die Schaltung in einem integrierten Schaltkreis verwirklicht ist, auf der Masseleitung, die auf ein externes Bezugspotential geführt ist, nur ein entsprechend geringer Anteil des Signalstroms fließt und damit auf dieser Masseleitung auch nur entsprechend geringe Spannungsabfälle eintreten. Dies ist wünschenswert, da diese auf den Masseleitungen auftretenden Spannungsabfälle für andere in dem IC gegebenenfalls vorhandene Schaltungselemente bedeuten, daß infolge dieser Spannungsabfälle sich das Bezugspotential für diese anderen Schaltungen entsprechend ändert. Dies bedeutet, daß das Ausgangssignal der Verstärkeranordnung über diese auf der Masseleitung auftretenden Spannungen auf andere in dem IC vorhandene Schaltungselemente übertragen wird. Dies bedeutet für diese Schaltungselemente ein Übersprechen des Ausgangsstroms der Verstärkeranordnung und damit eine Verringerung von deren Störabstand. Diese negativen Einflüsse werden durch die erfindungsgemäße Verstärkeranordnung wesentlich verringert.

**Patentansprüche**

**1.** Verstärkeranordnung
   - mit einem ersten Differenzverstärker, der einen ersten ($Q_1$) und einen zweiten Transistor ($Q_2$) aufweist, deren Emitter über einen gemeinsamen ersten Widerstand ($R_9$)mit einem Bezugspotential gekoppelt sind, wobei der Kollektor des ersten Transistors ($Q_1$) einen Ausgangsknoten ($K_{12}$) der Verstärkeranordnung bildet,
   - mit einem zweiten Differenzverstärker, dem eingangsseitig das Eingangssignal der Verstärkeranordnung zugeführt wird, der ausgangsseitig mit der Basis des ersten Transistors ($Q_1$) des ersten Differenzverstärkers gekoppelt ist und der einen invertierenden Eingang aufweist, der mit dem Ausgangsknoten ($K_{12}$) der Verstärkeranordnung gekoppelt ist,
   - mit einer ersten Stromspiegelanordnung, deren Eingangstransistor ($Q_5$) ein Referenzstrom zugeführt wird, deren Ausgangstransistor ($Q_2$) mit dem zweiten Transistor ($Q_2$) des ersten Differenzverstärkers identisch ist und deren beide Transistoren ($Q_5$, $Q_2$) emitterseitig mit einem Bezugspotential gekoppelt sind,
   - und mit einer zweiten Stromspiegelanordnung, der eingangsseitig das Ausgangssignal der ersten Stromspiegelanordnung zugeführt wird, die ausgangsseitig mit dem Ausgangsknoten ($K_{12}$) der Verstärkeranordnung gekoppelt ist, deren beide Transistoren ($Q_4$, $Q_3$) emitterseitig mit einem Versorgungspotential gekoppelt sind und deren Transistoren ($Q_4$, $Q_3$) bezüglich ihres Flächenverhältnisses so ausgelegt sind, daß die Stromspiegelanordnung ausgangsseitig einen gegenüber dem ihr zugeführten Eingangsstrom doppelt so großen Strom liefert.

**2.** Verstärkeranordnung nach Anspruch 1,
dadurch gekennzeichnet, daß der Emitter des Eingangstransistors ($Q_5$) der ersten Stromspiegelanordnung über einen zweiten Widerstand ($R_{10}$) mit Bezugspotential gekoppelt ist, am dem etwa eine Spannung des gleichen Spannungswertes abfällt wie an dem ersten Widerstand ($R_9$).

**3.** Verstärkeranordnung nach einem der Ansprüche 1 oder 2, dadurch gekennzeichnet, daß das Eingangssignal der Verstärkeranordnung einem nicht-invertierenden Eingang (61) des zweiten Differenzverstärkers zugeführt wird und daß ein invertierender Eingang (62) des zweiten Differenzverstärkers mit dem Ausgangsknoten ($K_{12}$) der Verstärkeranordnung und dem halben Wert des Versorgungspotentials gekoppelt ist.

**4.** Verstärkeranordnung nach einem der Ansprüche 1 bis 3, dadurch gekennzeichnet, daß das Versorgungspotential gegenüber dem Bezugspotential einen positiven Spannungswert aufweist, daß die beiden Transistoren ($Q_1$, $Q_2$) des ersten Differenzverstärkers sowie der Eingangstransistor ($Q_5$) der ersten Stromspiegelanordnung vom Leitfähigkeitstyp NPN sind und daß die beiden Transistoren ($Q_4$, $Q_3$) der zweiten Stromspiegelanordnung vom Leitfähigkeitstyp PNP sind.

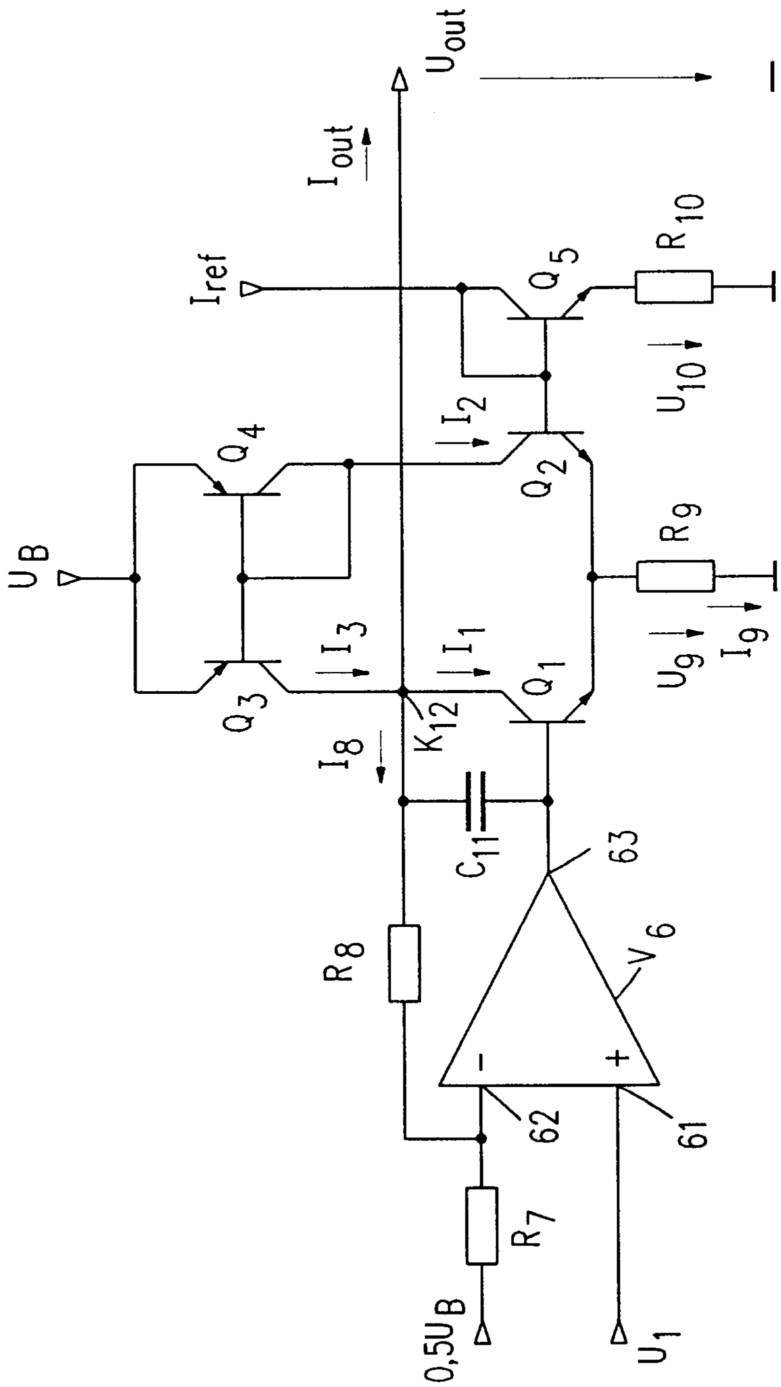
U_B
Q_3
Q_4
I_3
I_1
I_2
Q_1
Q_2
Q_5
K_12
I_8
I_ref
I_out
U_out
C_11
R_8
R_7
R_9
R_10
U_9
I_9
U_10
63
V_6
62
61
0,5U_B
U_1